# EUROPEAN PATENT APPLICATION

(11) **EP 4 336 806 A1**
(43) Date of publication of application: **13.03.2024**
(21) Application number: 22820548.0
(22) Date of filing: 08.06.2022
(51) Int. Cl.: H04M 1/02, G06F 1/16

(54) **HINGE DEVICE AND ELECTRONIC DEVICE COMPRISING HINGE DEVICE**

(30) Priority: 09.06.2021 KR 20210074666
(71) Applicant: Samsung Electronics Co., Ltd., Suwon-si, Gyeonggi-do 16677 (KR)
(72) Inventor: PARK, Joongkyung, Suwon-si, Gyeonggi-do 16677 (KR); PARK, Junghoon, Suwon-si, Gyeonggi-do 16677 (KR); SHIN, Wonho, Suwon-si, Gyeonggi-do 16677 (KR)
(74) Representative: Appleyard Lees IP LLP
(86) International application number: PCT/KR2022/008064
(87) International publication number: WO 2022/260420

(57) **Abstract**

A hinge device according to various embodiments disclosed in the present document may comprise: a bracket including a first coupling portion and a second coupling portion that is spaced apart from the first coupling portion; a first body portion including a first plate, and a first rotation portion which is coupled to the first plate and fastened to the first coupling portion of the bracket, so as to rotate with respect to the bracket; a second body portion including a second plate, and a second rotation portion which is coupled to the second plate and fastened to the second coupling portion of the bracket, so as to rotate with respect to the bracket; and a torque provision unit including a pressure plate arranged on the bracket, and an elastic member fixed to the bracket to press the pressure plate so that the pressure plate is in contact with the first rotation portion and the second rotation portion. Various other embodiments are also possible.

## Description

### [Technical Field]

Various embodiments disclosed herein relate to a hinge device and an electronic device including a hinge device.

### [Background Art]

Hinge structures are widely used throughout the industry as structures for rotatably connecting mechanical elements. For example, hinge structures may be applied to foldable electronic devices.

In line with technical development of components included in electronic devices, various types of electronic devices have been developed. Particularly, displays capable of folding have been developed as a result of technical development of displays for visually displaying information, and new concepts of electronic devices have emerged accordingly.

For example, a foldable electronic device may be implemented by applying a display capable of folding. The emergence of electronic devices having such a new form factor has been followed by increasing demands for technical development regarding components for rotatably connecting housings of electronic devices.

### [Disclosure of Invention]

### [Technical Problem]

In order to increase usability in a folding process of a foldable electronic device, a stop operation and a pre-stop operation may be necessary. The stop operation may refer to an operation in which the electronic device maintains a fully folded state or a fully unfolded state. The pre-stop operation may refer to an operation in which, if at least a predetermined level of external force is not applied while the electronic device switches from a folded state to an unfolded state, the electronic device maintains that state.

Particularly, it is important to implement portable electronic devices in compact sizes, and hinge devices included in electronic devices thus need to be designed compact. In addition, a problem may occur in the durability of a hinge device as components of the hinge device wear each other in order to implement a stop operation and a pre-stop operation.

Various embodiments disclosed herein may provide a hinge device which is configured in a comparatively simple structure and thus is implemented in a compact size, and which have improved durability.

### [Solution to Problem]

A hinge device according to various embodiments disclosed in the document may include a bracket including a first coupling part and a second coupling part spaced apart from the first coupling part, a first body part including a first plate and a first rotation part coupled to the first plate and fastened to the first coupling part of the bracket so as to rotate with respect to the bracket, a second body part including a second plate and a second rotation part coupled to the second plate and fastened to the second coupling part of the bracket so as to rotate with respect to the bracket, and a torque providing part including a pressing plate disposed on the bracket and an elastic member fixed to the bracket and configured to press the pressing plate so that the pressing plate comes into contact with the first rotation part and the second rotation part.

An electronic device according to various embodiments disclosed in the document may include a display, a first housing, a second housing, and a hinge device configured to rotatably connect the first housing and the second housing, wherein the hinge device may include a bracket including a first coupling part and a second coupling part spaced apart from the first coupling part, a first body part which includes a first plate and a first rotation part coupled to the first plate and fastened to the first coupling part of the bracket so as to rotate with respect to the bracket and is configured to support a first area of the display, a second body part which includes a second plate and a second rotation part coupled to the second plate and fastened to the second coupling part of the bracket so as to rotate with respect to the bracket and is configured to support a second area of the display, and a torque providing part including a pressing plate disposed on the bracket and an elastic member fixed to the bracket and configured to press the pressing plate so that the pressing plate comes in contact with the first rotation part and the second rotation part.

### [Advantageous Effects of Invention]

According to various embodiments disclosed herein, a hinge device may be implemented in a comparatively simple structure such that a compact hinge device can be fabricated. Accordingly, the hinge driving part of the electronic device may have a reduced volume such that the electronic device can be fabricated compact as a whole.

In addition, the force for implementing the stop operation or pre-stop operation of the electronic device may be freely adjusted, and the durability of the hinge device may be improved.

### [Brief Description of Drawings]

In connection with the description of the drawings, same or similar reference numerals will be used to refer to same or similar elements.
FIG. 1A is a view showing an unfolded state of an electronic device according to various embodiments of the disclosure.
FIG. 1B is a view showing a folded state of the electronic device in FIG. 1A according to various embodiments of the disclosure.
FIG. 1C is an exploded perspective view of an electronic device 100 according to various embodiments of the disclosure.
FIG. 2A is a perspective view of a hinge device according to various embodiments disclosed in the document.
FIG. 2B shows a plan view and a side view of a hinge device according to various embodiments disclosed in the document.
FIG. 2C is an exploded perspective view of a hinge device according to various embodiments disclosed in the document.
FIG. 3 is a cross-sectional view of the hinge device taken along line A-A illustrated in FIG. 2A.
FIG. 4A is a view showing an operation of a hinge device in case that an electronic device is in a folded state.
FIG. 4B is a view showing an operation of a hinge device in case that an electronic device is in an intermediate state.
FIG. 4C is a view showing an operation of a hinge device in case that an electronic device is in an unfolded state.
FIG. 5 is a view showing a form in which a hinge device according to various embodiments disclosed in the document is disposed in an electronic device.
FIG. 6 is an exploded perspective view of a hinge device according to another embodiment disclosed in the document.

### [Mode for the Invention]

It should be appreciated that various embodiments of the disclosure and the terms used therein are not intended to limit the technological features set forth herein to particular embodiments and include various changes, equivalents, or alternatives for a corresponding embodiment.

With regard to the description of the drawings, similar reference numerals may be used to designate similar or relevant elements. A singular form of a noun corresponding to an item may include one or more of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

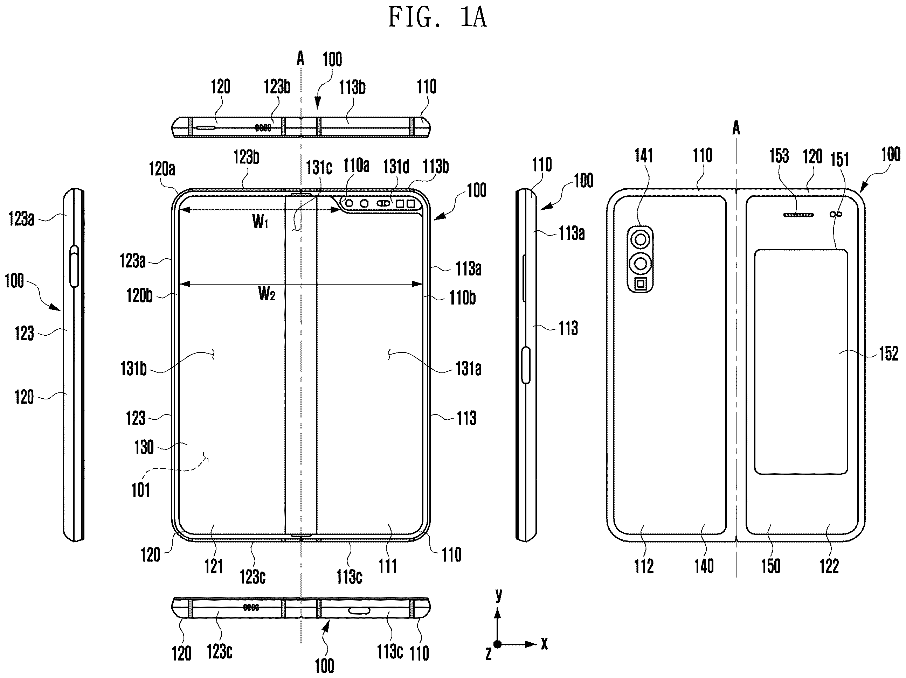

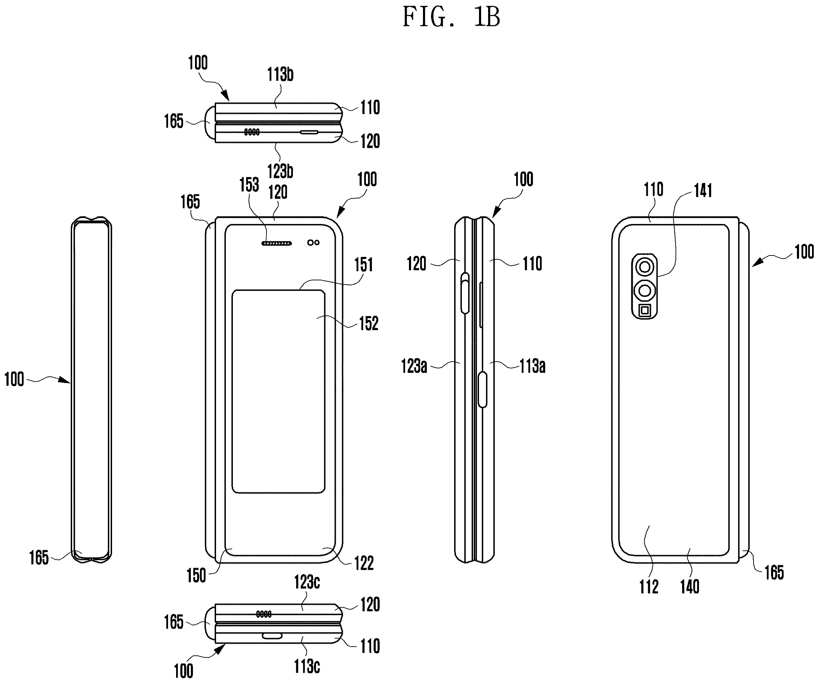

FIG. 1A is a view showing an unfolded state of an electronic device 100 according to various embodiments of the disclosure. FIG. 1B is a view showing a folded state of the electronic device 100 in FIG. 1A according to various embodiments of the disclosure.

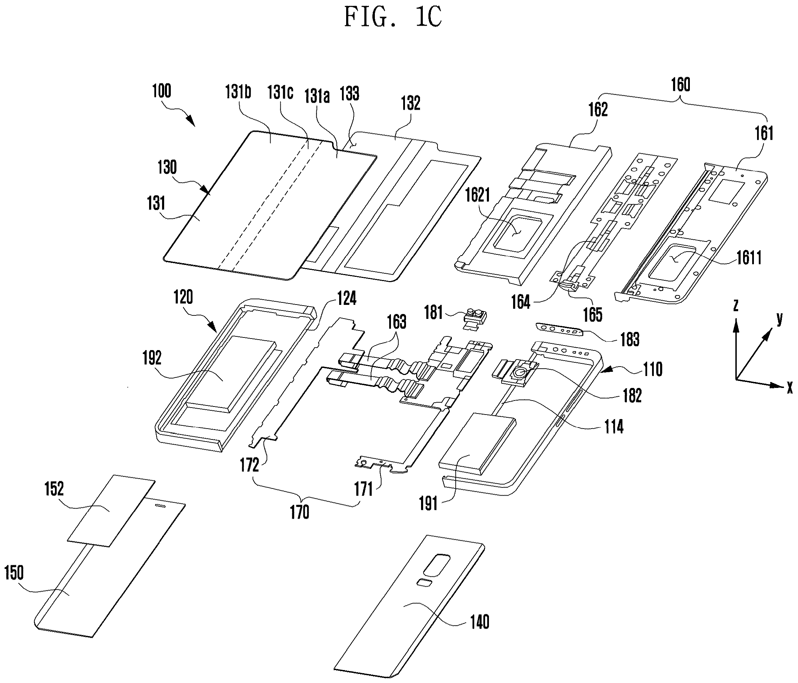

Referring to FIG. 1A, an electronic device 100 may include one pair of housings 110 and 120 (e.g., a foldable housing structure) rotatably coupled through a hinge (e.g., the hinge 164 in FIG. 1C) to be folded to each other, a hinge cover (e.g., the hinge cover 165 in FIG. 1B) for covering a portion at which the one pair of housings 110 and 120 are foldable, and a display 130 (e.g., a flexible display, a foldable display, or a first display) disposed in a space formed by the one pair of housings 110 and 120.

In the document, a surface, on which the display 130 is disposed, may be defined as the front surface of the electronic device 100, and a surface opposite to the front surface may be defined as the rear surface of the electronic device 100.

In the document, a surface, which surrounds a space between the front surface and the rear surface, may be defined as a side surface of the electronic device 100.

In the document, the direction, in which the front surface is oriented, may be defined as a first direction, and the direction, in which the rear surface is oriented, may be defined as a second direction.

In describing a stacking order (e.g., the order in which a display is stacked) in the document, the expression "a layer B is formed above a layer A" may mean that the layer B is formed in the first direction from the layer A. Alternatively, in describing a stacking order (e.g., the order in which a display is stacked) in the document, the expression "a layer B is formed below a layer A" may mean that the layer B is formed in the second direction from the layer A.

In an embodiment, the one pair of housings 110 and 120 may include a first housing 110 including a sensor area 131d, a second housing 120, a first rear cover 140, and a second rear cover 150. The one pair of housings 110 and 120 of the electronic device 100 is not limited to the shape and the combination illustrated in FIG. 1A and FIG. 1B, and may be implemented by other shapes or a combination and/or coupling of components. For example, in another embodiment, the first housing 110 and the first rear cover 140 may be integrally formed, and the second housing 120 and the second rear cover 150 may be integrally formed.

According to an embodiment, the first housing 110 and the second housing 120 may be arranged at both sides with reference to a folding axis (the axis A), and may have a substantially symmetrical shape with respect to the folding axis (the axis A). According to an embodiment, the first housing 110 and the second housing 120 may have different angles formed by each other or different distances from each other according to whether the state of the electronic device 100 is an unfolded state (a flat stage or an unfolding state), a folded state (a folding state), or an intermediate state. According to an embodiment, differently from the second housing 120, the first housing 110 may additionally include the sensor area 131d in which various sensors are arranged. However, the first housing and the second housing may have a mutually symmetrical shape in other areas. In another embodiment, the sensor area 131d may be additionally disposed in or may also be replaced with at least partial area of the second housing 120.

In an embodiment, the electronic device 100 may be configured such that the first housing 110 rotates with respect to the second housing 120 by means of a hinge (e.g., the hinge 164 in FIG. 1C) within a range of 0 degrees - 360 degrees, and thus may operate in an in-folding manner and/or in an out-folding manner. According to various embodiments, the hinge 164 may be formed in a lengthwise direction or a widthwise direction thereof when the electronic device 100 is seen from above. According to various embodiments, multiple hinges 164 may be provided. For example, all of the multiple hinges may be arranged in the same direction. As another example, some hinges among the multiple hinges may be arranged in directions different from each other to be folded.

In an embodiment, in an unfolded state of the of the electronic device 100, the first housing 110 may include a first surface 111 connected to a hinge (e.g., the hinge 164 in FIG. 1C) and disposed to face the front surface of the electronic device 100, a second surface 112 oriented in a direction opposite to the first surface 111, and a first lateral member 113 for surrounding at least a part of a space between the first surface 111 and the second surface 112. In an embodiment, the first lateral member 113 may include a first side surface 113a disposed parallel to a folding axis (the axis A), a second side surface 113b extending from one end of the first side surface 113a in a direction perpendicular to the folding axis, and a third side surface 113c extending from the other end of the first side surface 113a in a direction perpendicular to the folding axis (the axis A).

In an embodiment, in an unfolded state of the of the electronic device 100, the second housing 120 may include a third surface 121 connected to a hinge (e.g., the hinge 164 in FIG. 1C) and disposed to face the front surface of the electronic device 100, a fourth surface 122 oriented in a direction opposite to the third surface 121, and a second side member 123 for surrounding at least a part of a space between the third surface 121 and the fourth surface 122. In an embodiment, the second lateral member 123 may include a fourth side surface 123a disposed parallel to a folding axis (the axis A), a fifth side surface 123b extending from one end of the fourth side surface 123a in a direction perpendicular to the folding axis (the axis A), and a sixth side surface 123c extending from the other end of the fourth side surface 123a in a direction perpendicular to the folding axis (the axis A). In an embodiment, the third surface 121 may face the first surface 111 in a folded state.

In an embodiment, the electronic device 100 may include a recess 101 formed by a structural shape coupling between the first housing 110 and the second housing 120 so as to accommodate the display 130. The recess 101 may have substantially the same size as the display 130. In an embodiment, due to the sensor area 131d, the recess 101 may have two widths different from each other in a direction perpendicular to a folding axis (axis A). For example, the recess 101 may have a first width W1 between a first portion 120a of the second housing 120, which is parallel to the folding axis (the axis A), and a first portion 110a of the first housing 110, which is formed at the periphery of the sensor area 131d, and a second width W2 formed by a second portion 120b of the second housing 120 and a second portion 110b of the first housing 110, which is other than the sensor area 131d of the first housing 210 and is parallel to the folding axis (the axis A). In this case, the second width W2 may be formed to be longer than the first width W1. For example, the recess 101 may be formed to have the first width W1 which is formed from the first portion 110a of the first housing 110 to the first portion 120a of the second housing 120 and has a mutually asymmetric shape, and the second width W2 which is formed from the second portion 110b of the first housing 110 to the second portion 120b of the second housing 120 and has a mutually symmetrical shape. In an embodiment, the first portion 110a and the second portion 110b of the first housing 110 may be formed to have distances different from a folding axis (the axis A). The width of the recess 101 is not limited to the illustrated example. In an embodiment, the recess 101 may also have two or more widths different from each other by the shape of the sensor area 131d or portions of the first housing 110 and the second housing 120, which have an asymmetric shape.

In an embodiment, at least a part of the first housing 110 and the second housing 120 may be formed of a metal material or non-metal material having the rigidity of a size selected for supporting the display 130.

In an embodiment, the sensor area 131d may be formed to have a predetermined area adjacent to a side corner of the first housing 110. However, the arrangement, shape, or size of the sensor area 131d is not be limited to the illustrated example. For example, in another embodiment, the sensor area 131d may be provided in other corners of the housing 110 or any area between the top corner and the bottom corner thereof. As another embodiment, the sensor area 131d may also be disposed in at least a partial area of the second housing 120. As another embodiment, the sensor area 131d may also be disposed to extend from the first housing 110 and the second housing 120. In an embodiment, the electronic device 100 may include components for performing various functions, which are arranged to be exposed on the front surface of the electronic device 100 through the sensor area 131d or through one or more openings provided through the sensor area 131d. In an embodiment, for example, the components may include at least one of a front camera device, a receiver, a proximity sensor, an illuminance sensor, an iris recognition sensor, an ultrasonic sensor, or an indicator.

In an embodiment, the first rear cover 140 may be disposed on the second surface 112 of the first housing 110 and may have a substantially rectangular periphery. In an embodiment, at least a part of the periphery may be surrounded by the first housing 110. Similarly thereto, a second rear cover 150 may be disposed on the fourth surface 122 of the second housing 120, and at least a part of the periphery thereof may be surrounded by the second housing 120.

In the illustrated embodiment, the first rear cover 140 and the second rear cover 150 may have a substantially symmetrical shape with reference to a folding axis (the axis A). As another embodiment, the first rear cover 140 and the second rear cover 150 may also include various shapes different from each other. As another embodiment, the first rear cover 140 may be integrally formed with the first housing 110, and the second rear cover 150 may be integrally formed with the second housing 120.

In an embodiment, the first rear cover 140, the second rear cover 150, the first housing 110, and the second housing 120 may provide a space, in which various components (e.g., a printed circuit board, antenna module, a sensor module, or a battery) of the electronic device 100 can be arranged, through a structure formed by being coupled to one another. In an embodiment, one or more components may be arranged or may be visually exposed on the rear surface of the electronic device 100. For example, one or more components or sensors may be visually exposed through a first rear area 141 of the first rear cover 140. In an embodiment, the sensors may include a proximity sensor, a rear camera device, and/or a flash. In another embodiment, at least a part of a sub-display 152 (e.g., a second display) may be visually exposed through a second rear area 151 of the second rear cover 150. In another embodiment, the electronic device 100 may also include a speaker module 153 disposed through at least a partial area of the second rear cover 150.

The display 130 may be disposed above a space formed by the one pair of housings 110 and 120. For example, the display 130 may be seated in the recess 101 formed by the one pair of housings 110 and 120, and may be disposed to substantially occupy the majority of the front surface of the electronic device 100. Accordingly, the front surface of the electronic device 100 may include the display 130, and a partial area (e.g., the periphery area) of the first housing 110 and a partial area (e.g., the periphery area) of the second housing 120, which are adjacent to the display 130. In an embodiment, the rear surface of the electronic device 100 may include the first rear cover 140, a partial area (e.g., the periphery area) of the first housing 110, which is adjacent to the first rear cover 140, the second rear cover 150, and a partial area (e.g., the periphery area) of the second housing 120, which is adjacent to the second rear cover 150.

In an embodiment, the display 130 may mean a display of which at least a partial area is transformable into a flat surface or a curved surface. In an embodiment, the display 130 may include a folding area 131c, a first area 131a disposed at one side (e.g., the right area of the folding area 131c) with reference to the folding area 131c, and a second area 131b disposed at the other side (e.g., the left area of the folding area 131c) thereof. For example, the first area 131a may be disposed on the first surface 111 of the first housing 110, and the second area 131b may be disposed on the third surface 121 of the second housing 120. In an embodiment, the division of the area of the display 130 may be exemplary, and the area of the display 130 may also be divided into multiple (e.g., four or more, or two) areas according to a structure or a function thereof. For example, in the embodiment illustrated in FIG. 1A, the area of the display 130 may be divided by a folding axis (the axis A) or the folding area 131c extending parallel to the y-axis. However, in another embodiment, the area of the display 130 may also be divided with reference to another folding area (e.g., a folding area parallel to the x-axis) or another folding axis (e.g., a folding axis parallel to the x-axis). The division of the area of the display described above may be merely a physical division by the one pair of housings 110 and 120 and a hinge (e.g., the hinge 164 in FIG. 1C), and substantially, the display 130 may be displayed as one entire screen through the one pair of housings 110 and 120 and the hinge (e.g., the hinge 164 in FIG. 1C). In an embodiment, the first area 131a and the second area 131b may have an overall symmetrical shape with reference to the folding area 131c. However, differently from the second area 131b, the first area 131a may include a notch area (e.g., the notch area 133 in FIG. 1C) which is cut according to the presence of the sensor area 131d, but may have a symmetrical shape with the second area 131b in an area other than the sensor area. For example, the first area 131a and the second area 131b may include portions having shapes symmetric to each other, and portions having shapes asymmetric to each other.

Referring to FIG. 1B, a hinge cover 165 may be disposed between the first housing 110 and the second housing 120, and be configured to cover an internal component (e.g., the hinge 164 in FIG. 1C). In an embodiment, the hinge cover 165 may be covered by a part of the first housing 110 and the second housing 120 or may be exposed to the outside, according to an operation state (e.g., an unfolded state (a flat state) or a folded state) of the electronic device 100.

As an example, in case that the electronic device 100 is in an unfolded state as illustrated in FIG. 1A, the, the hinge cover 165 may be covered by the first housing 110 and the second housing 120 and thus may not be exposed. As an example, in case that the electronic device 100 is in a folded state (e.g., a completely folded state) as illustrated in FIG. 1B, the hinge cover 165 may be exposed to the outside between the first housing 110 and the second housing 120. For example, in case that the electronic device is in an intermediate state in which the first housing 110 and the second housing 120 are folded with a certain angle, the hinge cover 165 may be at least partially exposed to the outside of the electronic device 100, between the first housing 110 and the second housing 120. In this case, the exposed area may be smaller than that in the completely folded state. In an embodiment, the hinge cover 165 may include a curved surface.

Hereinafter, an operation of the first housing 110 and the second housing 120 and each area of the display 130 according to an operation state (e.g., an unfolded state (a flat state) and a folded state) of the electronic device 100 will be described.

In an embodiment, in case that the electronic device 100 is in an unfolded state (a flat state) (e.g., the state in FIG. 1A), the first housing 110 and the second housing 120 may form angle of 180 degrees, and thus the first area 131a and the second area 131b of a display may be arranged to be oriented in the same direction. In addition, the folding area 131c may form the same plane as the first area 131a and the second area 131b. As another embodiment, in case that the electronic device 100 is in an folded state , the first housing 110 and the second housing 120 may be reversely folded such that the second surface 112 and the fourth surface 122 face each other, and thus the first area 131a and the second area 131b of a display may also be arranged to be oriented in directions opposite to each other.

In an embodiment, in case that the electronic device 100 is in a folded state (e.g., the state in FIG. 1B), the first housing 110 and the second housing 120 may be arranged to face each other. The first area 131a and the second area 131b of the display 130 may form a narrow angle (e.g., angle between 0 degrees and 10 degrees), and may also face each other. At least a part of the folding area 131c may be formed as a curved surface having a predetermined curvature.

In an embodiment, in case that the electronic device 100 is in an intermediate state, the first housing 110 and the second housing 120 may be arranged to have a certain angle each other. The first area 131a and the second area 131b of the display 130 may form angle larger than that of a folded state and smaller than that of an unfolded state. At least a part of the folding area 131c may be formed as a curved surface having a predetermined curvature, and at this time, the curvature may be smaller than that of a folded state.

FIG. 1C is an exploded perspective view of an electronic device 100 according to various embodiments of the disclosure.

Referring to FIG. 1C, in an embodiment, the electronic device 100 may include the display 130, a support member assembly 160, at least one printed circuit board 170, the first housing 110, the second housing 120, the first rear cover 140, and the second rear cover 150. In the document, the display (display unit) 130 (e.g., a first display) may be referred to as a display module or a display assembly.

The display 130 may include a display panel 131 (e.g., a flexible display panel) and one or more plates 132 or layers on which the display panel 131 is seated. In an embodiment, the one or more plates 132 may include a conductive plate (e.g., a Cu sheet or a SUS sheet) disposed between the display panel 131 and the support member assembly 160. According to an embodiment, the conductive plate may be formed to have substantially the same area as the display, and the area of the conductive plate, which faces the folding area of the display, may be formed to be bendable. The plate 132 may include at least one sub-material layer (e.g., a graphite member) disposed on the rear surface of the display panel 131. In an embodiment, the plate 132 may be formed in a shape corresponding to the display panel 131. For example, a partial area of the plate 132 may be formed in a shape corresponding to the notch area 133 of the display panel 131.

The support member assembly 160 may include a first support member 161 (e.g., a first support plate), a second support member 162 (e.g., a second support plate), the hinge 164 disposed between the first support member 161 and the second support member 162, the hinge cover 165 for covering the hinge 164 in case of being seen from the outside thereof, and at least one wire member 163 (e.g., a flexible printed circuit board (FPCB)) crossing the first support member 161 and the second support member 162.

In an embodiment, the support member assembly 160 may be disposed between the plate 132 and the at least one printed circuit board 170. As an example, the first support member 161 may be disposed between the first area 131a of the display 130 and a first printed circuit board 171. The second support member 162 may be disposed between the second area 131b of the display 130 and a second printed circuit board 172.

In an embodiment, at least a part of the wire member 163 and the hinge 164 may be arranged inside the support member assembly 160. The wire member 163 may be disposed in a direction (e.g., the x-axis direction) crossing the first support member 161 and the second support member 162. The wire member 163 may be disposed in a direction (e.g., the x-axis direction) perpendicular to a folding axis (e.g., the y-axis or the folding axis A in FIG. 1A) of the folding area 131c.

In an embodiment, as mentioned above, the at least one printed circuit board 170 may include the first printed circuit board 171 disposed at the side of the first support member 161 and the second printed circuit board 172 disposed at the side of the second support member 162. The first printed circuit board 171 and the second printed circuit board 172 may be arranged in a space formed by the support member assembly 160, the first housing 110, the second housing 120, the first rear cover 140, and the second rear cover 150. Components for implementing various functions of the electronic device 100 may be mounted on the first printed circuit board 171 and the second printed circuit board 172.

In an embodiment, the first printed circuit board 171 disposed in a space formed through the first support member 161, a first battery 191 disposed at a position facing a first swelling hole 1611 of the first support member 161, at least one sensor module 181, or at least one camera module 182 may be included in a first space of the first housing 110. The first housing 110 may include a window glass 183 disposed to protect at least one sensor module 181 and at least one camera module 182 at a position corresponding to the notch area 133 of the display 130. In an embodiment, the second printed circuit board 172 disposed in a second space formed through the second support member 162, and a second battery 192 disposed at a position facing a second swelling hole 1621 of the second support member 162 may be included in a second space of the second housing 120. According to an embodiment, the first housing 110 and the first support member 161 may be integrally formed. According to an embodiment, the second housing 120 and the second support member 162 may also be integrally formed. According to an embodiment, the sub-display 152 may be disposed in a second space of the second housing 120. According to an embodiment, the sub-display 152 (e.g., a second display) may be disposed to be visible from the outside through at least a partial area of the second rear cover 150.

In an embodiment, the first housing 110 may include a first rotation support surface 114, and the second housing 120 may include a second rotation support surface 124 corresponding to the first rotation support surface 114. Each of the first rotation support surface 114 and the second rotation support surface 124 may include a curved surface corresponding to a curved surface included in the hinge cover 165.

In an embodiment, in case that the electronic device 100 is in an unfolded state (e.g., the state in FIG. 1A), the first rotation support surface 114 and the second rotation support surface 124 may cover the hinge cover 165 so as not to expose or minimally expose the hinge cover 165 to the rear surface of the electronic device 100. In an embodiment, in case that the electronic device 100 is in a folded state in (e.g., the state in FIG. 1B), the first rotation support surface 114 and the second rotation support surface 124 may rotate along a curved surface included in the hinge cover 165 to maximally expose the hinge cover 165 to the rear surface of the electronic device 100.

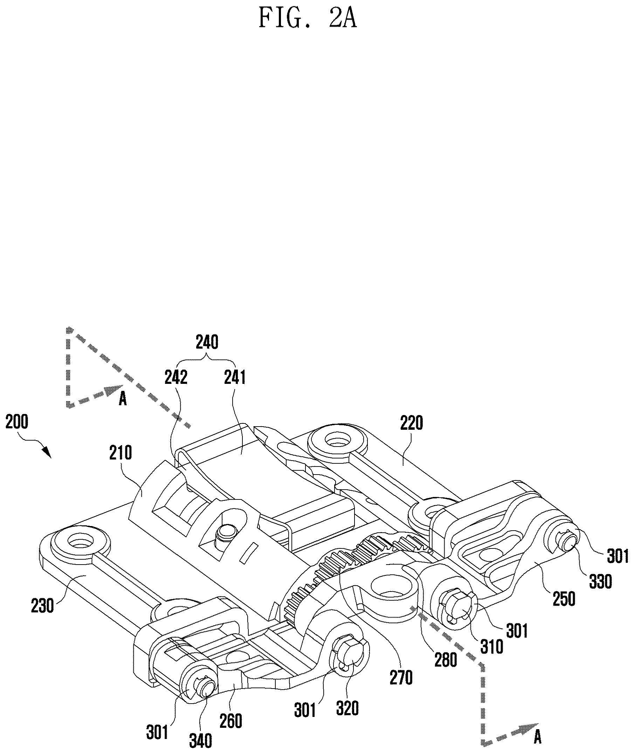

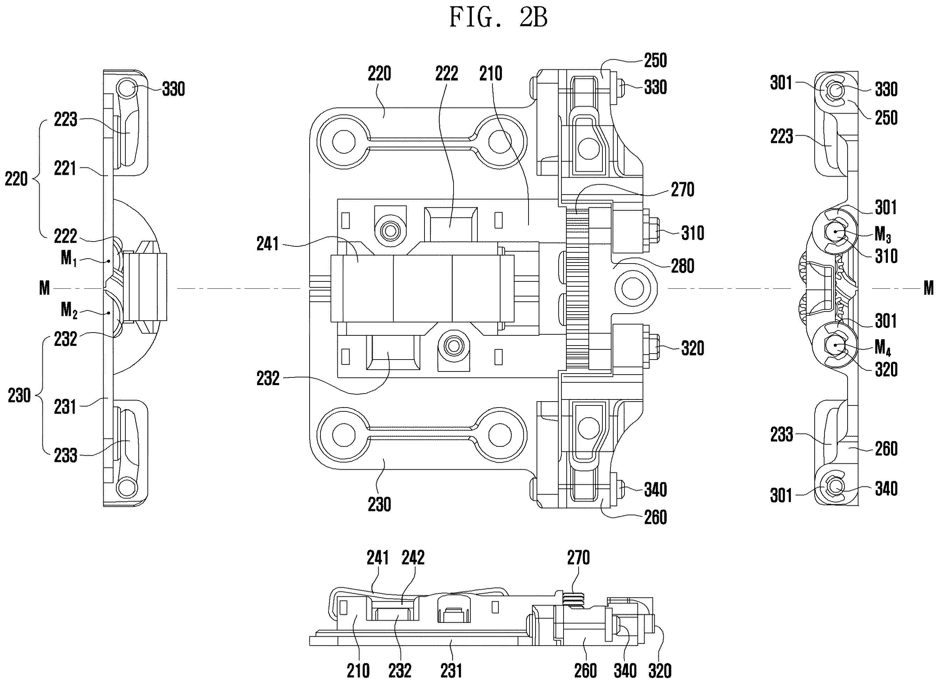

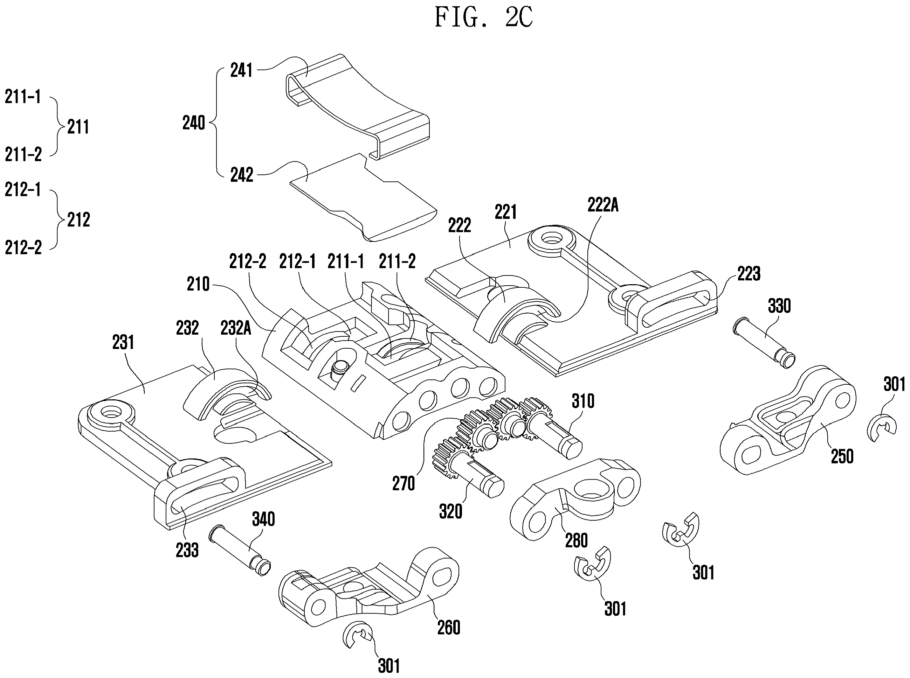

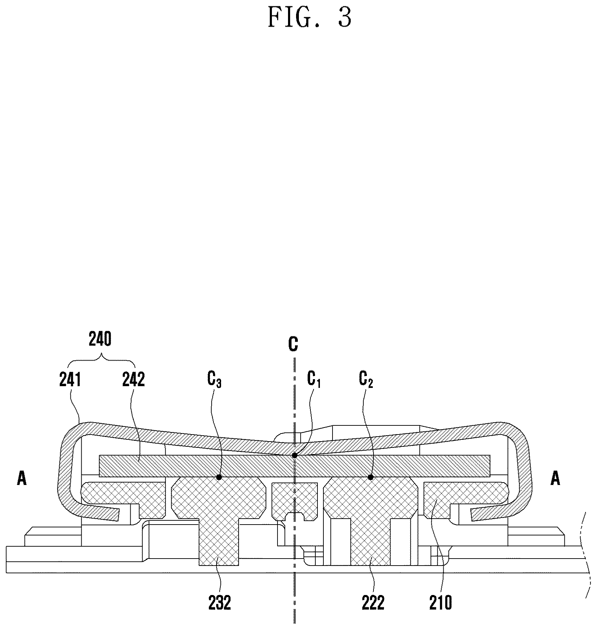

FIG. 2A is a perspective view of a hinge device according to various embodiments disclosed in the document. FIG. 2B includes a plan view of FIG. 2B) and side views of FIG. 2B) of a hinge device according to various embodiments disclosed in the document. FIG. 2C is an exploded perspective view of a hinge device according to various embodiments disclosed in the document. FIG. 3 is a cross-sectional view of the hinge device taken along line A-A illustrated in FIG. 2A.

A hinge device 200 described below may be included in the electronic device 100 described previously through FIG. 1A to FIG. 1C. For example, the hinge device 200 may be included in the hinge 164 in FIG. 1C. The hinge device 200 may be installed between a first housing (e.g., the first housing 110 in FIG. 1A) and a second housing (e.g., the second housing 120 in FIG. 1A) of the electronic device to rotatably connect the first housing and the second housing. For example, the electronic device may be switched to a folded state (e.g., the state illustrated in FIG. 1B), an intermediate state, and an unfolded state (e.g., the state illustrated in FIG. 1A) according to the degree of rotation of the first housing and the second housing by the hinge device 200. In FIG. 1A, an electronic device, which is folded in the longitudinal direction (e.g., the axis A in FIG. 1A) thereof as an axis, is illustrated as an example, but the hinge device 200 described in the document may also be used for a folding operation of an electronic device which is folded in a width direction perpendicular to the longitudinal direction as an axis. In addition, the hinge device 200 disclosed in the document may be used in various electronic devices employing a mechanical member installed to enable relative rotation.

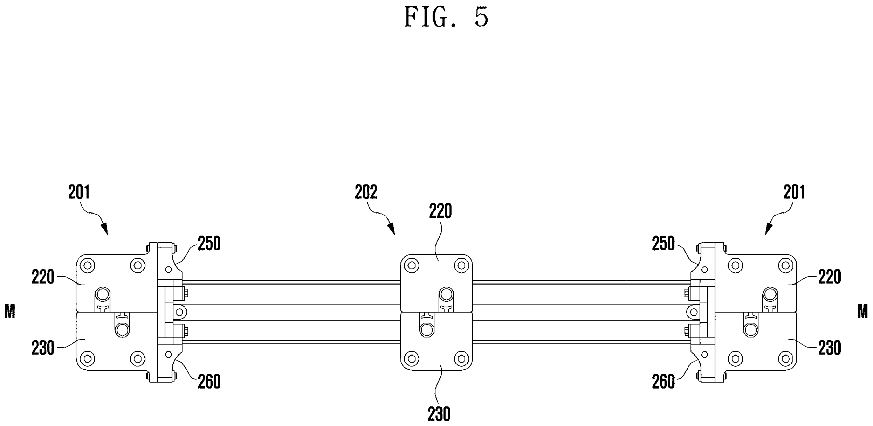

Referring to FIG. 2A to FIG. 2C, the hinge device 200 may include a bracket 210, a first body part 220, a second body part 230, a torque providing part 240, a first arm 250, a second arm 260, and an interlocking member 270. The elements of the hinge device 200 described above are only an example, at least one of the above-described configurations may be omitted as necessary, and it may also be possible to configure the hinge device 200 by adding other elements. For example, the first arm 250, the second arm 260, and the interlocking member 270 may be omitted as necessary. Referring to FIG. 5, in the hinge device of an electronic device, a hinge device 201 including the first arm 250, the second arm 260, and the interlocking member 270, and a hinge device 202 not including the first arm 250, the second arm 260, and the interlocking member 270 may be installed and used together.

In an embodiment, the bracket 210 may be a body of the hinge device 200, which allows elements of the hinge device 200 to be coupled to each other. Elements of the hinge device 200 may be arranged and be mutually coupled or interlocked with reference to the bracket 210. With respect to the center of the bracket 210, the first body part 220 and the second body part 230 may rotate and the first arm 250 and the second arm 260 may rotate. The center M of the bracket 210 may be the rotation center M of the hinge device 200. Therefore, the bracket 210 may be disposed in the electronic device so that the center M of the bracket 210 and the rotation center (e.g., the axis A in FIG. 1A) of the electronic device coincide with each other. The bracket 210 may be formed of various materials. For example, the bracket 210 may be formed of a metal material or a synthetic resin material. The bracket 210 may be formed of a highly rigid material to stably support various elements of the hinge device 200.

Referring to FIG. 2C, the bracket 210 may include a first coupling part 211 and a second coupling part 212. The first coupling part 211 may be a portion to which a first rotation part 222 of the first body part 220 is fastened. The second coupling part 212 may be a portion to which a second rotation part 232 of the second body part 230 is fastened. The first rotation part 222 may be fastened to the first coupling part 211 so that the first rotation part 222 is rotatable with respect to the bracket 210. The second rotation part 232 may be fastened to the second coupling part 212 so that the second rotation part 232 is rotatable with respect to the bracket 210.

For example, the first coupling part 211 may include a first opening 211-1 and a first rotation guide 211-2. The first opening 211-1 may be formed through the bracket 210. The first rotation guide 211-2 may be a portion formed to protrude toward the first opening 211-1. The first rotation guide 211-2 may be inserted into a first rotation rail 222A formed in the first rotation part 222. The first rotation guide 211-2 and the first rotation rail 222A may be formed to have shapes corresponding to each other. The first rotation guide 211-2 and the first rotation rail 222A may be formed to have circular cross sections. In a state where the first rotation guide 211-2 of the first coupling part 211 is inserted into the first rotation rail 222A of the first rotation part 222, the first rotation part 222 may rotate with respect to the bracket 210. The center M1 of the first rotation guide 211-2 and the first rotation rail 222A may be the rotation center M1 of the first rotation part 222 rotating with respect to the bracket 210.

For example, the second coupling part 212 may include a second opening 212-1 and a second rotation guide 212-2. The second opening 212-1 may be formed through the bracket 210. The second rotation guide 212-2 may be a portion formed to protrude toward the second opening 212-1. The second rotation guide 212-2 may be inserted into a second rotation rail 232A formed in the second rotation part 232. The second rotation guide 212-2 and the second rotation rail 232A may be formed to have shapes corresponding to each other. The second rotation guide 212-2 and the second rotation rail 232A may be formed to have circular cross sections. In a state where the second rotation guide 212-2 of the second coupling part 212 is inserted into the second rotation rail 232A of the second rotation part 232, the second rotation part 232 may rotate with respect to the bracket 210. The center M2 of the second rotation guide 212-2 and the second rotation rail 232A may be the rotation center M2 of the second rotation part 232 rotating with respect to the bracket 210.

In an embodiment, the first coupling part 211 and the second coupling part 212 may be formed to be spaced apart from each other. For example, the first coupling part 211 may be disposed in a first direction (e.g., the first direction in FIG. 2C) with respect to a portion of the bracket 210, which faces the center of a pressing plate 242 of the torque providing part 240. The second coupling part 212 may be disposed in a second direction (e.g., the second direction in FIG. 2C) opposite to the first direction with respect to the portion of the bracket 210, which faces the center of the pressing plate 242 of the torque providing part 240. According to the formation positions of the first coupling part 211 and the second coupling part 212, the first rotation part 222 fastened to the first coupling part 211 and the second rotation part 232 fastened to the second coupling part 212 may also be arranged at positions different from each other. The pressing plate 242, and the first rotation part 222 and the second rotation part 232 may be in contact with each other. A portion in which the first rotation part 222 is in contact with the pressing plate 242 and a portion in which the second rotation part 232 is in contact with the pressing plate 242 may be spaced by the same distance from the center of the pressing plate 242 (see FIG. 3).

In an embodiment, the first body part 220 and the second body part 230 may be installed on the bracket 210 so as to be rotatable with respect to the bracket 210. The first body part 220 may include a first plate 221 and the first rotation part 222. The second body part 230 may include a second plate 231 and a second rotation part 232.

In an embodiment, the first plate 221 and the second plate 231 may support a display (e.g., the display 130 in FIG. 1A). The display may include a first area (e.g., the first area 131a in FIG. 1A), a second area (e.g., the second area 131b in FIG. 1A), and a third area (e.g., the folding area 131c in FIG. 1A) between the first area and the second area. The first area, the second area, and the third area may be areas of the display, which are conceptually divided for explanation, and may not be areas which are visually divided. The first plate 221 may support a first area of the display of the electronic device. The second plate 231 may support a second area of the electronic device. The first plate 221 and the second plate 231 may rotate with respect to the bracket 210, and thus the first area and the second area of the display may also rotate with respect to the bracket 210. In case that the first area and the second area of the display rotate, the first area and the second area may be bent with respect to the third area.

In an embodiment, the first rotation part 222 may be coupled to the first plate 221. The first rotation part 222 and the first plate 221 may move together. For example, the first rotation part 222 may be integrally formed with the first plate 221, and the first rotation part 222 may be coupled to the first plate 221 by using various coupling methods (e.g., bolt coupling, rivet coupling, adhesive coupling, welding coupling). The second rotation part 232 may be coupled to the second plate 231. The second rotation part 232 and the second plate 231 may move together. For example, the second rotation part 232 may be integrally formed with the second plate 231, and the second rotation part 232 may be coupled to the second plate 231 by using various coupling methods (e.g., bolt coupling, rivet coupling, adhesive coupling, welding coupling).

The first rotation part 222 may be rotatably installed with respect to the bracket 210, and thus the first plate 221 may rotate with respect to the bracket 210. The second rotation part 232 of the second body part 230 may be rotatably installed with respect to the bracket 210, and thus the second plate 231 may rotate with respect to the bracket 210. The rotation of the first plate 221 with respect to the bracket 210 may be performed around the center of the first rotation rail 222A formed in the first rotation part 222 as the rotation center M1. Hereinafter, the rotation center of the first plate 221 will be referred to as the first rotation center M1. The rotation of the second plate 231 with respect to the bracket 210 may be performed around the center of the second rotation rail 232A formed in the second rotation part 232 as the rotation center M2. Hereinafter, the rotation center of the second plate 231 will be referred to as the second rotation center M2.

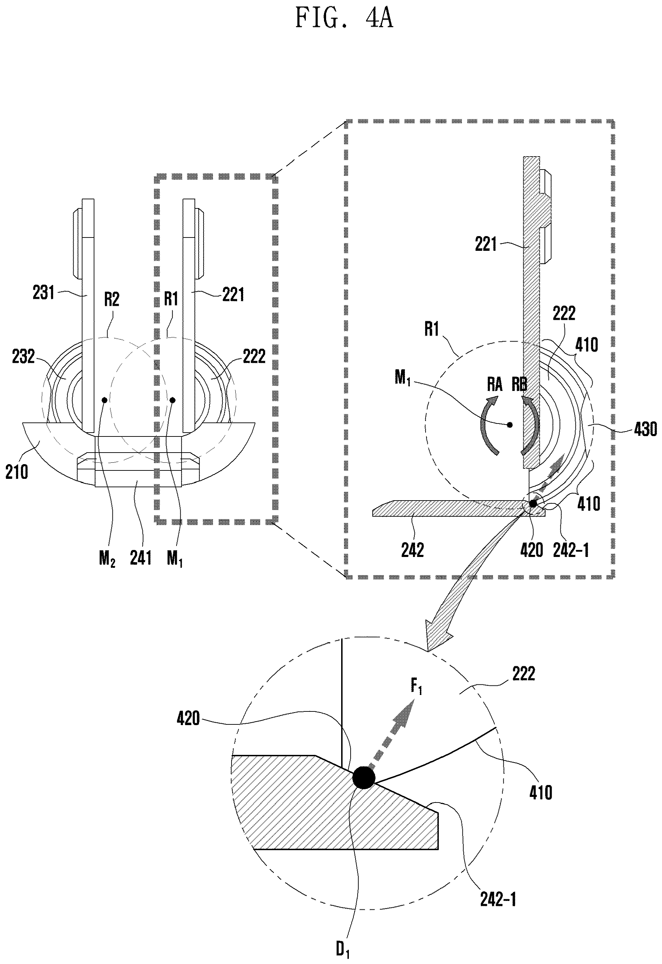

Referring to FIG. 2B, in (b) of FIG. 2B, when seeing the hinge device 200, the first rotation part 222 and the second rotation part 232 may be arranged on the bracket 210 so that the first rotation part 222 and the second rotation part 232 partially overlap each other. For example, the first rotation part 222 and the second rotation part 232 may be arranged such that the rotation radius (e.g., the R1 in FIG. 4A) of the first rotation part 222 and the rotation radius (e.g., the R2 in FIG. 4A) of the second rotation part 232 overlap each other.

The spaced distance between the first rotation center M1 and the second rotation center M2 may be determined according to the folding curvature of the display. Here, the folding curvature may mean a curvature which allows the display to be stably folded. The folding curvature may be a design specification of the display, and may be variously changed according to a design of the display. For example, the folding curvature may be changed according to a material constituting the display and a support structure of the display. The rotation of the first body part 220 and the second body part 230 may be performed by the rotation of the first rotation part 222 and the second rotation part 232 with respect to the bracket 210. The radius (e.g., the R1 in FIG. 4A) of the first rotation rail 222A of the first rotation part 222 and the radius (e.g., the R2 in FIG. 4A) of the second rotation rail 232A of the second rotation part 232 may be largely formed such that the first rotation part 222 and the second rotation part 232 are stably installed on the bracket 210. Since the spaced distance between the first rotation center M1 and the second rotation center M2 is determined by the folding curvature of the display, in order to increase the radius of the first rotation rail 222A and the radius of the second rotation rail 232A, the radius of the first rotation rail 222A and the radius of the second rotation rail 232A may overlap each other. The first rotation part 222 may be disposed on the first coupling part 211 formed in the first direction with respect to a portion of the bracket 210, which faces the center of the pressing plate 242, the second rotation part 232 may be disposed on the second coupling part 212 formed in the second direction opposite to the first direction, in (b) of FIG. 2B, when seeing the hinge device 200, the first rotation part 222 and the second rotation part 232 may partially overlap each other, and thus the radius of the first rotation rail 222A and the radius of the second rotation rail 232A may be formed as large as required.

In an embodiment, the torque providing part 240 may include the pressing plate 242 and an elastic member 241. The pressing plate 242 may be formed in a plate shape and disposed on the bracket 210. The elastic member 241 may be fixed to the bracket 210 and be configured to press the pressing plate 242.

For example, as illustrated in FIG. 2A and FIG. 3, the elastic member 241 may be a flat spring having opposite ends fixed to the bracket 210. Referring to FIG. 3, the elastic member 241 may be a flat spring having a shape in which a middle portion C thereof is bent in the direction of the pressing plate 242. The pressing plate 242 disposed between the bracket 210 and the elastic member 241 may be pressed toward the bracket 210 by the elastic member 241. In an embodiment, the shape of the pressing plate 242 and the elastic member 241 may be adjusted and the position of the pressing plate 242 and the elastic member 241 with respect to the bracket 210 may be determined, such that the elastic member 241 presses the center C1 of the pressing plate 242. For example, referring to FIG. 3, the elastic member 241 may press the center C1 of the pressing plate 242, and the first rotation part 222 and the second rotation part 232 may come into contact with the pressing plate 242 at positions C2 and C3 which are symmetrical with respect to the center C1 of the pressing plate 242. Due to the symmetrical structure, the elastic force provided to the pressing plate 242 by the elastic member 241 may be uniformly delivered to the first rotation part 222 and the second rotation part 232.

The pressing plate 242 of the torque providing part 240 may come into contact with the first rotation part 222 and the second rotation part 232, so that a force may be provided to the first rotation part 222 and the second rotation part 232. The force provided by the pressing plate 242 may be involved in an operation (hereinafter, referred to as a "stop operation") required a predetermined amount or more of external force in the rotation of the first rotation part 222 and the second rotation part 232. In case that there is no external force provided from the outside, the frictional force between the pressing plate 242, and the first rotation part 222 and the second rotation part 232 may be involved in an operation (hereinafter, referred to as a "free stop") in which a rotation of a hinge is stopped. Detailed descriptions thereof will be described later.

In an embodiment, the first arm 250 may be rotatably installed to the bracket 210. Referring to FIG. 2C, the first arm 250 may be rotatably installed to the bracket 210 by means of a first shaft 310 inserted into the bracket 210. The center of the first shaft 310 may be the rotation center M3 of the first arm 250. The first arm 250 may be connected to the first body part 220. The first arm 250 may be connected to the first body part 220 by means of a first pin 330. The second arm 260 may be rotatably installed to the bracket 210. Referring to FIG. 2C, the second arm 260 may be rotatably installed to the bracket 210 by means of a second shaft 320 inserted into the bracket 210. The center of second shaft 320 may be the rotation center M4 of the second arm 260. The second arm 260 may be connected to the second body part 230. The second arm 260 may be connected to the second body part 230 by means of a second pin 340.

In an embodiment, the interlocking member 270 may interlock the rotation of the first arm 250 and the second arm 260 with respect to the bracket 210. The first arm 250 and the second arm 260 may be interlocked by the interlocking member 270 and thus may be rotated with respect to the bracket 210. The first arm 250 and the second arm 260 may be interlocked to be rotated in opposite directions by the interlocking member 270. The first arm 250 and the second arm 260 may rotate together in a direction in which the electronic device is unfolded or folded. For example, as illustrated in FIG. 2A to FIG. 2C, the interlocking member 270 may include multiple gears. The multiple gears included in the interlocking member 270 may be an even number so that the first arm 250 and the second arm 260 rotate in conjunction with each other in opposite directions. Some of the multiple gears may be inserted around the first shaft 310 and the second shaft 320. In an embodiment, the interlocking member 270 may include an interlocking body 280. The interlocking body 280 may be inserted around the first shaft 310 and the second shaft 320. Referring to FIG. 2C, a gear of the interlocking member 270 - the first arm 250 - the interlocking body 280 may be inserted around the first shaft 310. A fixation member 301 fitted around the terminal end of the first shaft 310 may support so that elements inserted around the first shaft 310 are inserted around the first shaft 310 and are maintained. A gear of the interlocking member 270 - the second arm 260 - the interlocking body 280 may be inserted around the second shaft 320. A fixation member 301 fitted around the terminal end of the second shaft 320 may support so that elements inserted around the second shaft 320 are inserted around the second shaft 320 and are maintained.

In an embodiment, the first arm 250 and the first body part 220 may be connected by the first pin 330. The first arm 250 and the first body part 220 connected by the first pin 330 may rotate together with respect to the bracket 210. Referring to FIG. 2B, the rotation center M3 of the first arm 250 and the first rotation center M1 of the first body part 220 may be arranged at different positions. For this reason, the rotation trajectories of the first arm 250 and the first body part 220 may be different from each other. In order to compensate for the difference, the first pin 330 may be inserted into a first compensation rail 223 formed on the first body part 220. The first compensation rail 223 may be formed to extend in one direction on the first plate 221. In the process in which the first arm 250 and the first body part 220 rotate, the first pin 330 may move along the first compensation rail 223. The second arm 260 and the second body part 230 may be connected by the second pin 340. The second arm 260 and the second body part 230 connected by the second pin 340 may rotate together with respect to the bracket 210. Referring to FIG. 2B, the rotation center M4 of the second arm 260 and the second rotation center M2 of the second body part 230 may be arranged at different positions. For this reason, the rotation trajectories of the second arm 260 and the second body part 230 may be different from each other. In order to compensate for the difference, the second pin 340 may be inserted into a second compensation rail 233 formed on the second body part 230. The second compensation rail 233 may be formed to extend in one direction on the second plate 231. In the process in which the second arm 260 and the second body part 230 rotate, the second pin 340 may move along the second compensation rail 233. Since the first arm 250 and the first body part 220 are connected to each other and thus rotate together and the second arm 260 and the second body part 230 are connected to each other and thus rotate together, the rotation of the first body part 220 and the second body part 230 may also be interlocked by the interlocking member 270 interlocking the first arm 250 and the second arm 260. The interlocking member 270 may interlock the rotation of the first body part 220 and the second body part 230 so that the first body part 220 and the second body part 230 rotate in opposite directions. Referring to FIG. 2C, the fixation members 301 may be fitted around the terminal ends of the first pin 330 and the second pin 340, respectively, and thus the state, in which the first body part 220 and the first arm 250 are inserted around the first pin 330, may be maintained and the state, in which the second body part 230 and the second arm 260 are inserted around the second pin 340, may be maintained.

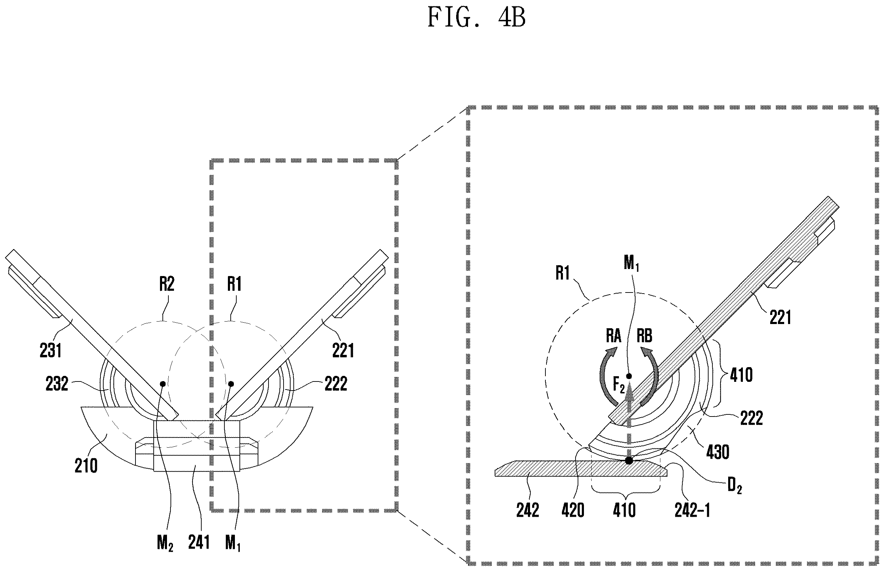

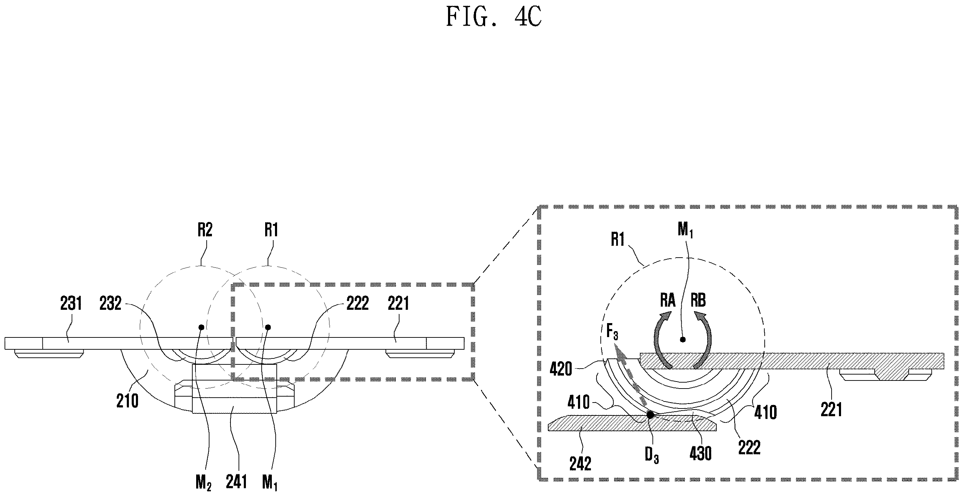

FIG. 4A to FIG. 4C are views showing an operation of a hinge device according to various embodiments disclosed in the document. FIG. 4A is a view showing an operation of a hinge device in case that an electronic device is in a folded state, FIG. 4B is a view showing an operation of a hinge device in case that an electronic device is in an intermediate state, and FIG. 4C is a view showing an operation of a hinge device in case that an electronic device is in an unfolded state.

In the description below, elements, which are identical to as or similar to the elements described previously in FIG. 2A to FIG. 2C, will be described using the same reference numerals, and descriptions overlapping those described above may be briefly described or be omitted. In addition, the contents (e.g., the first rotation center M1, the second rotation center M2, the stop operation, and the free stop) defined above may be used as the same meaning even in the description below.

The electronic device in the document may include a structure in which a first housing (e.g., the first housing 110 in FIG. 1A) and a second housing (e.g., the second housing 120 in FIG. 1A) are rotatably connected by the hinge device 200. For the convenience of description, a state according to a degree of rotation of the first housing and the second housing will be defined first. Hereinafter, a state where the first housing and the second housing face each other or a state where the terminal end of the first housing and the terminal end of the second housing are in close proximity to each other will be defined as "a folded state" (e.g., the state in FIG. 1B). Hereinafter, a state where the first housing and the second housing form substantially horizontal or a state where the terminal end of the first housing and the terminal end of the second housing are spaced apart from each other will be defined as "an unfolded state" (e.g., the state in FIG. 1A). An intermediate state of switching from a folded state to an unfolded state or an intermediate state of switching from an unfolded state to a folded state will be defined as "an intermediate state".

Referring to FIG. 4A to FIG. 4C, a rotation part (the first rotation part222 or the second rotation part 232) may include a circular part 410 having a circular cross section, a stop part 430 concavely formed on the circular part 410, and an end part 420 corresponding to one terminal end of the circular part 410. In the description below, in describing the rotation part, it will be described using the first rotation part 222. The second rotation part 232 may be a configuration corresponding to the first rotation part 222, and in the following description, the description of a "rotation part" may also be equally applied to the second rotation part 232.

As illustrated in FIG. 4A to FIG. 4C, the cross section of the rotation part 222 may be circular, but may be formed as a part of a circle rather than a complete circle. For this reason, a contact position between the rotation part 222 and the pressing plate 242 may be changed in the process in which the rotation part 222 rotates. For example, according to a degree of rotation of the rotation part, one of the circular part 410, the end part 420, and the stop part 430 of the rotation part may come into contact with the pressing plate 242. The contact position D1 between the rotation part 222 and the pressing plate 242 in case that the electronic device is in a folded state, the contact position D2 between the rotation part 222 and the pressing plate 242 in case that the electronic device is in an intermediate state, and the contact position D3 between the rotation part 222 and the pressing plate 242 in case that the electronic device is in an unfolded state may all be different.

Referring to FIG. 4A to FIG. 4C, the pressing plate 242 may include an inclined contact part 242-1 formed at each of opposite ends thereof to be inclined at a predetermined angle. According to a degree of rotation of the rotation part 222, the end part 420 of the rotation part 222 may come into contact with the inclined contact part 242-1.

Referring to FIG. 4A, in an embodiment, in case that the electronic device is in a folded state, the end part 420 of the rotation part 222 may come into contact with the inclined contact part 242-1 of the pressing plate 242. As illustrated in FIG. 4A, in case that the electronic device is in a folded state, the end part 420 may be formed at the terminal end of the circular part 410 in a shape corresponding to the inclination of the inclined contact part 242-1. In this state, the force F1 provided to the end part 420 by the inclined contact part 242-1 may provide torque capable of rotating the rotation part 222 in a direction RB opposite to the direction RA in which the rotation part 222 is unfolded. In case that the inclined surface of the inclined contact part 242-1 and the end part 420 come into contact, among the components of the force applied to the rotation part 222 by the inclined surface, a component of the force toward the tangent of the rotation part 222 may have a relatively large magnitude. The component of the force acting in the tangential direction of the rotation part 222 may generate torque for rotating the rotation part 222. Referring to FIG. 4A, in a folded state, the pressing plate 242 may provide torque in the direction RB in which the rotation part 222 is folded. Unless a force equal to or greater than the torque generated by the force F1 applied to the rotation part 222 by the pressing plate 242 is applied to the rotation part 222, the rotation part 222 may be maintained in a folded state. Accordingly, the stop operation of the electronic device may be implemented. The torque may be proportional to the diameter of the rotation part 222 and the force F1 applied to the rotation part 222 by the pressing plate 242. The force F1 applied to the rotation part 222 by the pressing plate 242 may be proportional to the elastic force of the elastic member 241. An intensity of a stop operation in a folded state may be adjusted by adjusting the diameter of the rotation part 222 and/or the elastic force of the elastic member 241.

Referring to FIG. 4B, in an embodiment, in case that the electronic device is in an intermediate state, the circular part 410 of the rotation part 222 may come into contact with the pressing plate 242. Referring to FIG. 4B, the force F2 provided to the rotation part 222 by the pressing plate 242 may be applied to the center M1 of the rotation part 222. Therefore, torque may not be generated in the rotation part 222 by the force F2 provided by the pressing plate 242. Rotation of the rotation part 222 may be hindered by a frictional force acting between the pressing plate 242 and the rotation part 222. In case that a force beyond the frictional force is not provided, the rotation part 222 may not rotate and thus be maintained in a stop state. Therefore, the free stop operation may be implemented. The frictional force between the pressing plate 242 and the rotation part 222 may be proportional to a reaction to a force provided to the rotation part 222 by the pressing plate 242 and a gravitational force acting on the rotation part 222. Since the force F2 provided by the pressing plate 242 is proportional to the elastic force of the elastic member 241, the frictional force between the pressing plate 242 and the rotation part 222 may be adjusted by adjusting the elastic force of the elastic member 241. In addition, in an intermediate state, the frictional force acting between a body part (e.g., the first body part 221 or the second body part 222 in FIG. 2C) and an arm (e.g., the first arm 250 or the second arm 260 in FIG. 2C) may be an element for implementing the free stop operation. As illustrated in FIG. 2A, the body part and the arm may come into close contact with each other in a state where the hinge device 200 is assembled thereto. In case that there is no external force, the frictional force between the body part and the arm may be one of the forces acting for the implementation of the free stop operation to stop the rotation of the body part in an intermediate state.

Referring to FIG. 4C, in an embodiment, in case that the electronic device is in an unfolded state, the stop part 430 of the rotation part 222 may come into contact with the pressing plate 242. Referring to FIG. 4C, the force F3 provided to the rotation part 222 by the pressing plate 242 may generate torque for rotating the rotation part 222 in the clockwise direction RA. The stop part 430 may be a portion concavely formed on the rotation part 222. In case that the pressing plate 242 comes into contact with the stop part 430, torque may be generated in the rotation part by the force F3 provided to the rotation part 222 by the pressing plate 242. The torque, which rotates the rotation part 222 in the clockwise direction RA, may be defined as a force which maintains the electronic device to an unfolded state. Unless a force equal to or greater than the torque generated by the force F3 applied to the rotation part 222 by the pressing plate 242 is applied to the rotation part 222, the rotation part 222 may be maintained in an unfolded state. Therefore, the stop operation of the electronic device may be implemented in an unfolded state.

In the hinge device 200 disclosed in the document, the rotation part 222 rotating with respect to the bracket 210 may come into contact with the pressing plate 242 of the torque providing part 240. The elastic member 241 of the torque providing part 240 may press the pressing plate 242, and the pressing plate 242 may press the rotation part 222 in contact with the pressing plate 242. The rotation part 222 may include a circular part 410 having a circular shape, an end part 420 which is a terminal end of the circular part 410, and a stop part 430 concavely formed on the circular part 410. Therefore, the contact points D1, D2, and D3 between the pressing plate 242 and the rotation part 222 may be changed according to a degree of rotation of the rotation part 222. Since the inclined contact part 242-1 of the pressing plate 242 and the end part 420 of the rotation part 222 are in contact with each other in case that the electronic device is in a folded state, a stop operation, in which the folded state is maintained by the force F1 provided to the rotation part 222 by the pressing plate 242, may be implemented. In case that the electronic device is in an intermediate state and an external force greater than the frictional force between the pressing plate and the circular part is not applied thereto, the free stop operation, in which rotation of the rotation part 222 stops, may be implemented by the frictional force between the pressing plate 242 and the circular part 410. In case that the electronic device is in an unfolded state, the pressing plate 242 may come into contact with the stop part 430 of the rotation part 222. At this time, the stop operation, in which the unfolded state is maintained, may be implemented by the force F3 provided to the stop part 430 by the pressing plate 242. The hinge device 200 according to various embodiments disclosed in the document may be configured such that both the stop operation and the free stop operation of a foldable electronic device are implemented through a relatively simple structure.

FIG. 5 is a view showing a form in which a hinge device according to various embodiments disclosed in the document is disposed in an electronic device.

In the below description, in connection with elements which are identical or similar to elements described in FIG. 2A to FIG. 2C, the same member numbers may be used, and detailed descriptions thereof may be omitted.

According to various embodiments, the hinge device 200 may or may not include an interlocking structure. Here, the interlocking structure may mean a configuration including the first arm 250, the second arm 260, and the interlocking member 270. When a hinge device 200 including the interlocking structure is referred to as a first hinge device 201 and a hinge device 200 not including an interlocking structure is referred to as a second hinge device 202, as illustrated in FIG. 5, the first hinge device 201 and the second hinge device 202 may be used together.

The first hinge device 201 may rotate the first body part 220 and the second body part 230 in directions opposite to each other in a folding and an unfolding operation of the electronic device so as to implement folding and unfolding, and thus may implement the stop operation and the free stop operation. The second hinge device 202 may reinforce the stop operation and the free stop operation in a folding and an unfolding operation of the electronic device.

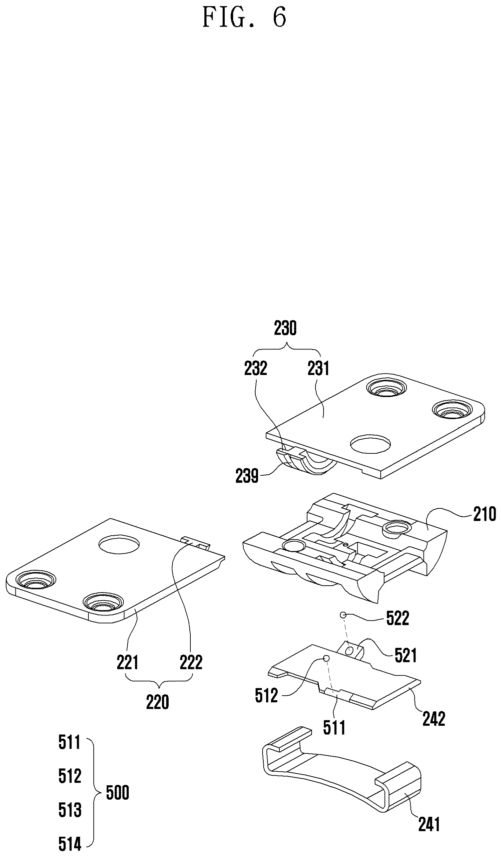

FIG. 6 is an exploded perspective view of a hinge device according to another embodiment disclosed in the document.

In the below description, in connection with elements which are identical or similar to elements described in FIG. 2A to FIG. 2C, the same member numbers may be used, and detailed descriptions thereof may be omitted.

According to various embodiments, the torque providing part 240 of the hinge device 200 may further include a bearing member 500. The bearing member 500 may include ball accommodation parts 511 and 521 formed on the pressing plate 242 and balls 512 and 522 seated on the ball accommodation parts 511 and 521.

According to various embodiments, rails 239 capable of accommodating the balls 512 and 522 seated in the ball accommodation parts 511 and 521 of the bearing member 500 may be respectively formed at portions of the first rotation part 222 and the second rotation part 232, which are in contact with the pressing plate 242. Although only the rail 239 formed on the second rotation part 232 is illustrated in FIG. 6, a rail for accommodating the ball 512 may also be formed on the first rotation part 222.

In the process in which the first body part 220 and the second body part 230 rotate with respect to the bracket 210, the balls 512 and 522 of the bearing member 500 may be accommodated in the rails of the first rotation part 222 and the rail 239 of the second rotation part 232, respectively, and may roll. As the balls 512 and 522 of the bearing member 500 roll according to the rotation of the first rotation part 222 and the second rotation part 232, the free stop operation may be alleviated.

A hinge device according to various embodiments disclosed in the document may include a bracket including a first coupling part and a second coupling part spaced apart from the first coupling part, a first body part including a first plate and a first rotation part coupled to the first plate and fastened to the first coupling part of the bracket so as to rotate with respect to the bracket, a second body part including a second plate and a second rotation part coupled to the second plate and fastened to the second coupling part of the bracket so as to rotate with respect to the bracket, and a torque providing part including a pressing plate disposed on the bracket and an elastic member fixed to the bracket and configured to press the pressing plate so that the pressing plate comes into contact with the first rotation part and the second rotation part.

In addition, the elastic member of the torque providing part may be configured to press a central part of the pressing plate, and the first rotation part and the second rotation part may be configured to come into contact with the pressing plate at positions symmetrical with respect to the central part.

In addition, the elastic member of the torque providing part may include a flat spring which has opposite ends coupled to the bracket and presses the pressing plate.

In addition, the pressing plate of the torque providing part may include inclined contact parts formed at opposite ends thereof to be inclined at a predetermined angle, and the first rotation part and the second rotation part may be configured to come into contact with the inclined contact parts according to a degree of rotation of the first body part and the second body part with respect to the bracket.

In addition, each of the first rotation part and the second rotation part may include a circular part having a circular cross section, a stop part concavely formed on the circular part, and an end part which is one terminal end of the circular part, and the pressing plate and at least one of the circular part, the stop part, and the end part may be configured to come into contact with each other according to a degree of rotation of the first body part and the second body part.

In addition, the first rotation part and the second rotation part may be configured such that the end parts thereof come into contact with the inclined contact parts of the pressing plate, respectively, according to a degree of rotation of the first body part and the second body part.

In addition, the first rotation part and the second rotation part may be configured such that at least parts of the stop parts thereof come into contact with the inclined contact parts of the pressing plate, respectively, according to a degree of rotation of the first body part and the second body part.

In addition, the torque providing part may further include a bearing member including ball accommodation parts formed on the pressing plate and balls seated in the ball accommodation parts, and the first rotation part and the second rotation part have rails formed thereon and configured to accommodate the balls of the bearing member, respectively.

In addition, a first arm rotatably installed with respect to the bracket and connected to the first body part, a second arm rotatably installed with respect to the bracket and connected to the second body part, and an interlocking member configured to interlock the rotation of the first arm and the second arm may be further included therein.

In addition, the first arm may be configured to rotate with respect to the bracket around a rotation axis different from that of the first body part and may be connected to the first body part through a first pin inserted into a first compensation rail formed in the longitudinal direction of the first body part, and the second arm may be configured to rotate with respect to the bracket around a rotation axis different from that of the second body part and may be connected to the second body part through a second pin inserted into a second compensation rail formed in the longitudinal direction of the second body part.

An electronic device according to various embodiments disclosed in the document may include a display, a first housing, a second housing, and a hinge device configured to rotatably connect the first housing and the second housing, wherein the hinge device may include a bracket including a first coupling part and a second coupling part spaced apart from the first coupling part, a first body part which includes a first plate and a first rotation part coupled to the first plate and fastened to the first coupling part of the bracket so as to rotate with respect to the bracket and is configured to support a first area of the display, a second body part which includes a second plate and a second rotation part coupled to the second plate and fastened to the second coupling part of the bracket so as to rotate with respect to the bracket and is configured to support a second area of the display, and a torque providing part including a pressing plate disposed on the bracket and an elastic member fixed to the bracket and configured to press the pressing plate so that the pressing plate comes in contact with the first rotation part and the second rotation part.

In addition, the elastic member of the torque providing part of the hinge device may be configured to press a central part of the pressing plate, and the first rotation part and the second rotation part may be configured to come into contact with the pressing plate at positions symmetrical with respect to the central part.

In addition, the elastic member of the torque providing part of the hinge device may include a flat spring which has opposite ends coupled to the bracket and presses the pressing plate.

In addition, the pressing plate of the torque providing part of the hinge device may include inclined contact parts formed at opposite ends thereof to be inclined at a predetermined angle, and the first rotation part and the second rotation part of the hinge device may be configured to come into contact with the inclined contact parts according to a degree of rotation of the first body part and the second body part with respect to the bracket.

In addition, each of the first rotation part and the second rotation part of the hinge device may include a circular part having a circular cross section, a stop part concavely formed on the circular part, and an end part which is one terminal end of the circular part, and the pressing plate and at least one of the circular part, the stop part, and the end part may be configured to come into contact with each other according to a degree of rotation of the first body part and the second body part.

In addition, the first rotation part and the second rotation part of the hinge device may be configured such that the end parts thereof come into contact with the inclined contact parts of the pressing plate, respectively, according to a degree of rotation of the first body part and the second body part.

In addition, the first rotation part and the second rotation part of the hinge device may be configured such that at least parts of the stop parts thereof come into contact with the inclined contact parts of the pressing plate, respectively, according to a degree of rotation of the first body part and the second body part.

In addition, the torque providing part 240 of the hinge device may further include a bearing member including ball accommodation parts formed on the pressing plate and balls seated in the ball accommodation parts, and the first rotation part and the second rotation part may have rails formed thereon and configured to accommodate the balls of the bearing member, respectively.

In addition, the hinge device may further include a first arm rotatably installed with respect to the bracket and connected to the first body part, a second arm rotatably installed with respect to the bracket and connected to the second body part, and an interlocking member configured to interlock the rotation of the first arm and the second arm.

In addition, the first arm of the hinge device may be configured to rotate with respect to the bracket around a rotation axis different from that of the first body part and may be connected to the first body part through a first pin inserted into a first compensation rail formed in the longitudinal direction of the first body part, and the second arm of the hinge device may be configured to rotate with respect to the bracket around a rotation axis different from that of the second body part and may be connected to the second body part through a second pin inserted into a second compensation rail formed in the longitudinal direction of the second body part.

The embodiments of the disclosure described and shown in the specification and the drawings are merely specific examples that have been presented to easily explain the technical contents of embodiments of the disclosure and help understanding of embodiments of the disclosure, and are not intended to limit the scope of the disclosure. Therefore, the scope of various embodiments of the disclosure should be construed to include, in addition to the embodiments set forth herein, all changes and modifications derived based on the technical idea of various embodiments of the disclosure.

## Claims

1. A hinge device comprising:
a bracket comprising a first coupling part and a second coupling part spaced apart from the first coupling part;
a first body part comprising a first plate and a first rotation part coupled to the first plate and fastened to the first coupling part of the bracket so as to rotate with respect to the bracket;
a second body part comprising a second plate and a second rotation part coupled to the second plate and fastened to the second coupling part of the bracket so as to rotate with respect to the bracket; and
a torque providing part comprising a pressing plate disposed on the bracket, and an elastic member fixed to the bracket and configured to press the pressing plate so that the pressing plate is in contact with the first rotation part and the second rotation part.

2. The hinge device of claim 1, wherein the elastic member of the torque providing part is configured to press a central part of the pressing plate, and
wherein the first rotation part and the second rotation part are configured to be in contact with the pressing plate at positions symmetrical with respect to the central part.

3. The hinge device of claim 2, wherein the elastic member of the torque providing part comprises a flat spring which has opposite ends coupled to the bracket and presses the pressing plate.

4. The hinge device of claim 1, wherein the pressing plate of the torque providing part comprises inclined contact parts formed at opposite ends thereof to be inclined at a predetermined angle, and
wherein the first rotation part and the second rotation part are configured to come into contact with the inclined contact parts according to a degree of rotation of the first body part and the second body part with respect to the bracket.

5. The hinge device of claim 4, wherein each of the first rotation part and the second rotation part comprises a circular part having a circular cross section, a stop part concavely formed on the circular part, and an end part which is one terminal end of the circular part, and
wherein the pressing plate and at least one of the circular part, the stop part, and the end part are configured to come into contact with each other according to a degree of rotation of the first body part and the second body part.

6. The hinge device of claim 5, wherein the first rotation part and the second rotation part are configured such that the end parts thereof come into contact with the inclined contact parts of the pressing plate, respectively, according to a degree of rotation of the first body part and the second body part.

7. The hinge device of claim 5, wherein the first rotation part and the second rotation part are configured such that at least parts of the stop parts thereof come into contact with the inclined contact parts of the pressing plate, respectively, according to a degree of rotation of the first body part and the second body part.

8. The hinge device of claim 1, wherein the torque providing part further comprises a bearing member comprising ball accommodation parts formed on the pressing plate and balls seated in the ball accommodation parts, and
wherein the first rotation part and the second rotation part have rails formed thereon and configured to accommodate the balls of the bearing member, respectively.

9. The hinge device of claim 1, further comprising:
a first arm rotatably installed with respect to the bracket and connected to the first body part;
a second arm rotatably installed with respect to the bracket and connected to the second body part; and
an interlocking member configured to interlock the rotation of the first arm and the second arm.

10. The hinge device of claim 9, wherein the first arm is configured to rotate with respect to the bracket around a rotation axis different from that of the first body part, and connected to the first body part through a first pin inserted into a first compensation rail formed in the longitudinal direction of the first body part, and
wherein the second arm is configured to rotate with respect to the bracket around a rotation axis different from that of the second body part, and connected to the second body part through a second pin inserted into a second compensation rail formed in the longitudinal direction of the second body part.

11. An electronic device comprising:
a display;
a first housing;
a second housing; and
a hinge device configured to rotatably connect the first housing and the second housing,
wherein the hinge device comprises:
a bracket comprising a first coupling part and a second coupling part spaced apart from the first coupling part;
a first body part which comprises a first plate and a first rotation part coupled to the first plate and fastened to the first coupling part of the bracket so as to rotate with respect to the bracket, and is configured to support a first area of the display;
a second body part which comprises a second plate and a second rotation part coupled to the second plate and fastened to the second coupling part of the bracket so as to rotate with respect to the bracket, and is configured to support a second area of the display; and
a torque providing part comprising a pressing plate disposed on the bracket, and an elastic member fixed to the bracket and configured to press the pressing plate so that the pressing plate is in contact with the first rotation part and the second rotation part.

12. The electronic device of claim 11, wherein the elastic member of the torque providing part of the hinge device is configured to press a central part of the pressing plate, and
wherein the first rotation part and the second rotation part are configured to be in contact with the pressing plate at positions symmetrical with respect to the central part.

13. The electronic device of claim 11, wherein the pressing plate of the torque providing part of the hinge device comprises inclined contact parts formed at opposite ends thereof to be inclined at a predetermined angle, and
wherein the first rotation part and the second rotation part of the hinge device are configured to come into contact with the inclined contact parts according to a degree of rotation of the first body part and the second body part with respect to the bracket.

14. The electronic device of claim 13, wherein each of the first rotation part and the second rotation part of the hinge device comprises a circular part having a circular cross section, a stop part concavely formed on the circular part, and an end part which is one terminal end of the circular part,
wherein the pressing plate and at least one of the circular part, the stop part, and the end part are configured to come into contact with each other according to a degree of rotation of the first body part and the second body part,
wherein the end parts are configured to come into contact with the inclined contact parts of the pressing plate according to a degree of rotation of the first body part and the second body part, and
wherein at least parts of the stop parts are configured to come into contact with the inclined contact parts of the pressing plate according to a degree of rotation of the first body part and the second body part.

15. The electronic device of claim 11, wherein the hinge device further comprises:
a first arm rotatably installed with respect to the bracket and connected to the first body part;
a second arm rotatably installed with respect to the bracket and connected to the second body part; and
an interlocking member configured to interlock the rotation of the first arm and the second arm,
wherein the first arm of the hinge device is configured to rotate with respect to the bracket around a rotation axis different from that of the first body part, and is connected to the first body part through a first pin inserted into a first compensation rail formed in the longitudinal direction of the first body part, and
wherein the second arm of the hinge device is configured to rotate with respect to the bracket around a rotation axis different from that of the second body part, and is connected to the second body part through a second pin inserted into a second compensation rail formed in the longitudinal direction of the second body part.
